# EUROPEAN PATENT APPLICATION

(11) **EP 4 807 787 A1**
(43) Date of publication of application: **16.09.2026**
(21) Application number: 24899690.2
(22) Date of filing: 27.11.2024
(51) Int. Cl.: H01L 21/67

(54) **SEMICONDUCTOR PROCESSING DEVICE**

(30) Priority: 05.12.2023 CN 202311664279; 29.10.2024 CN 202422632816 U
(71) Applicant: Huaying Research Co., Ltd, Wuxi, Jiangsu 214000 (CN)
(72) Inventor: WEN, Sophia Ziying, Wuxi, Jiangsu 214000 (CN); SHEN, Kerui, Wuxi, Jiangsu 214000 (CN)
(74) Representative: Sun, Yiming
(86) International application number: PCT/CN2024/134789
(87) International publication number: WO 2025/119050

(57) **Abstract**

The present invention discloses a semiconductor processing device and method. The semiconductor processing device comprises a first chamber and a second chamber. The first chamber has a first recessed groove, and the second chamber has a second recessed groove. When the second chamber is at the closed position relative to the first chamber and a wafer is accommodated between the second chamber and the first chamber, the first recessed groove and the second recessed groove communicate with each other and jointly form an edge channel, and an edge of the wafer extends into the edge channel. The second chamber or the first chamber has a first through-hole, a second through-hole, and a third through-hole that communicate the edge channel with the exterior, and an isolation protrusion located between the first through-hole and the second through-hole. An extraction liquid entering the edge channel through the first through-hole flows from the first through-hole to the third through-hole and flows out from the third through-hole, and an extraction liquid entering the edge channel through the second through-hole flows from the second through-hole to the third through-hole and flows out from the third through-hole. Thus, contamination extraction from the edge of the wafer can be achieved.

## Description

### TECHNICAL FIELD

The present invention relates to the field of semiconductor technology, and in particular to a semiconductor processing system and a semiconductor processing method.

### BACKGROUND

As semiconductor dimensions further decrease, impurities contained in the wafer silicon material itself have become a requirement for quality control monitoring. However, current wafer contamination detection techniques are limited to extracting and detecting contamination on the wafer surface or performing destructive testing on the entire wafer material.

Chinese patent application 201510836143.0 discloses a method for extracting and detecting wafer contamination using a sealed channel in a micro chamber. The sealed channel can only extract and detect surface contamination and bulk metal contamination of the wafer. However, in some applications, it is necessary to separately extract and detect contamination on the edge of the wafer.

Chinese patent application 201811040519.7 discloses a method and device for processing the edge of a semiconductor wafer using an edge micro-processing space. However, in some applications, it is impossible or difficult to extract and detect ultra-trace impurity contamination on the wafer edge.

Therefore, it is necessary to propose a new solution to overcome the problems in the existing technology.

It should be noted that the above description of the technical background is only for the convenience of clearly and completely explaining the technical solution of the present invention and for the convenience of understanding by the technical personnel in this field. It should not be considered that the above technical solutions are well known to those technical personnel in this field just because they are described in the background section of the present invention.

### SUMMARY

The present invention provides a semiconductor processing device and a semiconductor processing method, which can perform high-precision and convenient extraction and detection of contaminant impurities on the edge of a wafer.

To achieve the above objective, the present invention provides a semiconductor processing device, comprising: a first chamber; a second chamber movable relative to the first chamber between an open position and a closed position. When the second chamber is at the closed position relative to the first chamber, a wafer can be accommodated between the first chamber and the second chamber, and when the second chamber is at the open position relative to the first chamber, the wafer can be transferred into or out. The first chamber has a first recessed groove formed on its inner wall surface, and the second chamber has a second recessed groove formed on its inner wall surface; when the second chamber is at the closed position relative to the first chamber and the wafer is accommodated between the second chamber and the first chamber, the first recessed groove and the second recessed groove communicate with each other and jointly form an edge channel, and the edge of the wafer extends into the edge channel. The second chamber or the first chamber has a first through-hole, a second through-hole, and a third through-hole that communicate the edge channel with the exterior, and an isolation protrusion located between the first through-hole and the second through-hole, the first through-hole and the second through-hole being adjacently arranged, wherein an extraction liquid entering the edge channel through the first through-hole flows from the first through-hole to the third through-hole and flows out from the third through-hole, and an extraction liquid entering the edge channel through the second through-hole flows from the second through-hole to the third through-hole and flows out from the third through-hole.

According to another aspect of the present invention, the present invention provides a semiconductor processing method based on the above semiconductor processing device, comprising: driving a first segment of extraction liquid into the first segment edge channel through the first through-hole, and driving a second segment of extraction liquid into the second segment edge channel through the second through-hole, wherein due to tension, both the first segment of extraction liquid and the second segment of extraction liquid can fill corresponding positions of the edge channel where they are located; when the second segment of extraction liquid is located in the second segment edge channel, introducing a driving gas into the first segment edge channel through the first through-hole to drive the first segment of extraction liquid to the third through-hole and recovering the first segment of extraction liquid through the third through-hole, then driving a third segment of liquid into the first segment edge channel through the first through-hole, wherein due to tension, the third segment of liquid can fill the corresponding position of the edge channel where it is located, and then introducing a driving gas into the second segment edge channel through the second through-hole to drive the second segment of extraction liquid to the third through-hole and recovering the second segment of extraction liquid through the third through-hole; or, when the first segment of extraction liquid is located in the first segment edge channel, introducing a driving gas into the second segment edge channel through the second through-hole to drive the second segment of extraction liquid to the third through-hole and recovering the second segment of extraction liquid through the third through-hole, then driving a fourth segment of liquid into the second segment edge channel through the second through-hole, wherein due to tension, the fourth segment of liquid can fill the corresponding position of the edge channel where it is located, and then introducing a driving gas into the first segment edge channel through the first through-hole to drive the first segment of extraction liquid to the third through-hole and recovering the first segment of extraction liquid through the third through-hole.

According to another aspect of the present invention, the present invention provides a semiconductor processing device, comprising: a first chamber; a second chamber movable relative to the first chamber between an open position and a closed position, wherein when the second chamber is at the closed position relative to the first chamber, a wafer can be accommodated between the first chamber and the second chamber, and when the second chamber is at the open position relative to the first chamber, the wafer can be transferred into or out; the first chamber has a first segment recessed groove and a second segment recessed groove formed on its inner wall surface, and the second chamber has a third segment recessed groove and a fourth segment recessed groove formed on its inner wall surface; when the second chamber is at the closed position relative to the first chamber and the wafer is accommodated between the second chamber and the first chamber, the first segment recessed groove and the third segment recessed groove communicate with each other and jointly form a first segment edge channel, the second segment recessed groove and the fourth segment recessed groove communicate with each other and jointly form a second segment edge channel, a portion of the edge of the wafer extends into the first segment edge channel, and another portion of the edge of the wafer extends into the second segment edge channel, the second chamber or the first chamber has a first through-hole and a third through-hole that communicate the first segment edge channel with the exterior, and a second through-hole and a fourth through-hole that communicate the second segment edge channel with the exterior, one of the first through-hole and the third through-hole serving as an inlet of the first segment edge channel and the other of the first through-hole and the third through-hole serving as an outlet of the first segment edge channel, one of the second through-hole and the fourth through-hole serving as an inlet of the second segment edge channel and the other of the second through-hole and the fourth through-hole serving as an outlet of the second segment edge channel, wherein an extraction liquid is driven to enter the first segment edge channel through the corresponding inlet, flows through the first segment edge channel, and flows out through the corresponding outlet, and an extraction liquid is driven to enter the second segment edge channel through the corresponding inlet, flows through the second segment edge channel, and flows out through the corresponding outlet.

Compared with the existing technology, in the present invention, the extraction liquid entering the edge channel through the first through-hole flows from the first through-hole to the third through-hole and flows out from the third through-hole, and the extraction liquid entering the edge channel through the second through-hole flows from the second through-hole to the third through-hole and flows out from the third through-hole, thus enabling efficient extraction and detection of contaminant impurities on the edge of the wafer.

Therefore, it should be understood that providing this summary is only for the purpose of summarizing some embodiments to offer a basic understanding of some aspects of the present invention. Thus, the above embodiments are merely examples and should not be construed as narrowing the scope or spirit of the present invention in any way. Through reading the following detailed description and the accompanying drawings, the features, appearance and advantages of each embodiment will be apparent, and the drawings illustrate the principles of some embodiments by way of example.

### BRIEF DESCRIPTION OF THE DRAWINGS

The present invention may be better understood by referring to the drawings as well as the detailed description below. In particular, same numerals are used to refer to same structural parts throughout the drawings, and wherein:
FIG. 1 is a perspective structural view of the first chamber according to the first embodiment of the present invention;
FIG. 2 is a top view of the first chamber according to the first embodiment of the present invention;
FIG. 3 is a perspective structural view of the second chamber according to the first embodiment of the present invention;
FIG. 4 is a top view of the second chamber according to the first embodiment of the present invention;
FIG. 5 is an enlarged schematic diagram of a circle A shown in FIG. 4;
FIG. 6 is a cross-sectional view of the semiconductor processing device at a certain position according to the first embodiment, wherein the cross-section line corresponds to line E-E of FIG. 4;
FIG. 7 is an enlarged schematic diagram of a circle B shown in FIG. 6;
FIG. 8 is an enlarged schematic diagram of a circle C shown in FIG. 6;
FIG. 9 is a cross-sectional view of the semiconductor processing device at another position according to the first embodiment, wherein the cross-section line corresponds to line F-F of FIG. 4;
FIG. 10 is an enlarged schematic diagram of a circle D shown in FIG. 9;
FIG. 11 is a cross-sectional view of the semiconductor processing device at another position according to the first embodiment, wherein the cross-section line corresponds to line G-G of FIG. 4;
FIG. 12 is an enlarged schematic diagram of a circle H shown in FIG. 11;
FIG. 13 is a structural diagram of the edge channel and related structures of the semiconductor processing device;
FIGS. 14-15 are schematic diagrams illustrating the working principle of the edge channel and related structures in FIG. 13;
FIG. 16 is a flowchart of the semiconductor processing method in the first embodiment;
FIG. 17 is a perspective structural view of the first chamber in the second embodiment of the present invention;
FIG. 18 is a top view of the first chamber shown in FIG. 17;
FIG. 19 is a perspective structural view of the second chamber in the second embodiment of the present invention;
FIG. 20 is a top view of the second chamber shown in FIG. 19;
FIG. 21 is an enlarged schematic diagram of a circle L shown in FIG. 20;
FIG. 22 is an enlarged schematic diagram of a circle M shown in FIG. 20;
FIG. 23 is a cross-sectional view of the semiconductor processing device at a certain position according to the second embodiment, wherein the cross-section line corresponds to line X-X of FIG. 20;
FIG. 24 is an enlarged schematic diagram of a circle N shown in FIG. 23;
FIG. 25 is a cross-sectional view of the semiconductor processing device at a certain position according to the second embodiment, wherein the cross-section line corresponds to line Y-Y of FIG. 20;
FIG. 26 is an enlarged schematic diagram of a circle O shown in FIG. 25;
FIG. 27 is a cross-sectional view of the semiconductor processing device at a certain position according to the second embodiment, wherein the cross-section line corresponds to line Z-Z of FIG. 20;
FIG. 28 is an enlarged schematic diagram of a circle P shown in FIG. 27;
FIGS. 29-30 are schematic diagrams illustrating the working principle of the first segment edge channel and the second segment edge channel in the semiconductor processing device shown in FIG. 25;
FIG. 31 is a flowchart of the semiconductor processing method in the second embodiment.

### DETAILED DESCRIPTION OF THE PREFERRED EMBODIMENTS

Some embodiments of the present invention will be described more fully hereinafter with reference to the accompanying drawings, in which some, but not all embodiments are set forth. Indeed, various embodiments of the present invention may be embodied in many different forms and should not be construed as limited to the embodiments set forth herein; rather, these embodiments are provided so that the present invention will be thorough and complete, and will fully convey the scope of the present invention to the technical personnel in this field. For example, unless otherwise indicated, referring to something as a first, second, etc. should not be construed as implying a particular order. Also, something may be described as being above something else (unless otherwise indicated) but in fact may be below it, and vice versa; similarly, something described as being on the left may be on the right, and vice versa. The same reference numerals always refer to the same elements.

### First Embodiment

The present invention provides a semiconductor processing device that can efficiently and conveniently extract and detect contaminant impurities on the edge of a wafer.

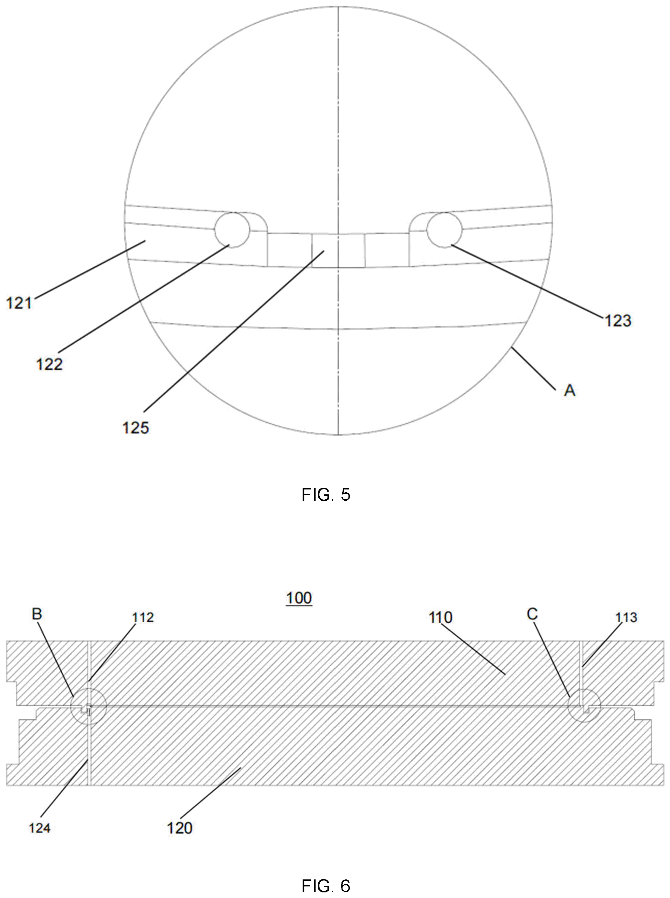

FIG. 6 is a cross-sectional view of the semiconductor processing device according to the first embodiment. As shown in FIG. 6, the semiconductor processing device 100 comprises comprises a first chamber 110 and a second chamber 120 movable relative to the first chamber 110 between an open position and a closed position. In this embodiment, the first chamber 110 is an upper chamber, and the second chamber 120 is a lower chamber, and the lower chamber is driven to move up and down so that the second chamber 120 moves relative to the first chamber 110 between the open position and the closed position. In another embodiment, the first chamber 110 may also be a lower chamber, and the second chamber 120 may be an upper chamber, and the upper chamber may be driven to move up and down so that the second chamber 120 moves relative to the first chamber 110 between the open position and the closed position. The movement between the second chamber 120 and the first chamber 110 is relative; it may be the second chamber 120 that moves, or the first chamber 110 that moves. When the second chamber 120 is at the closed position relative to the first chamber 110, a wafer 200 can be accommodated between the first chamber 110 and the second chamber 120, and when the second chamber 120 is at the open position relative to the first chamber 110, the wafer 200 can be transferred into or out.

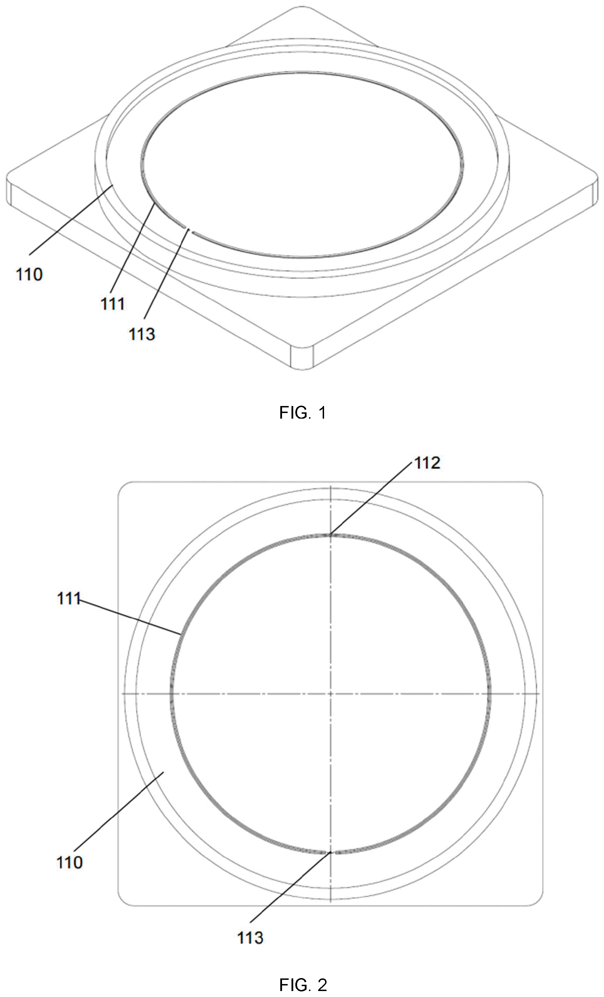

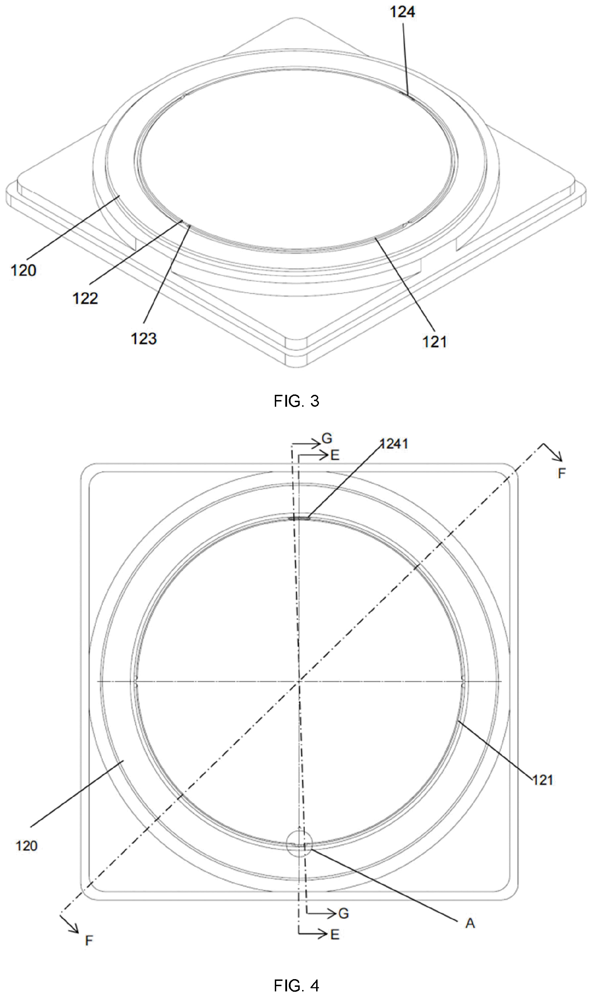

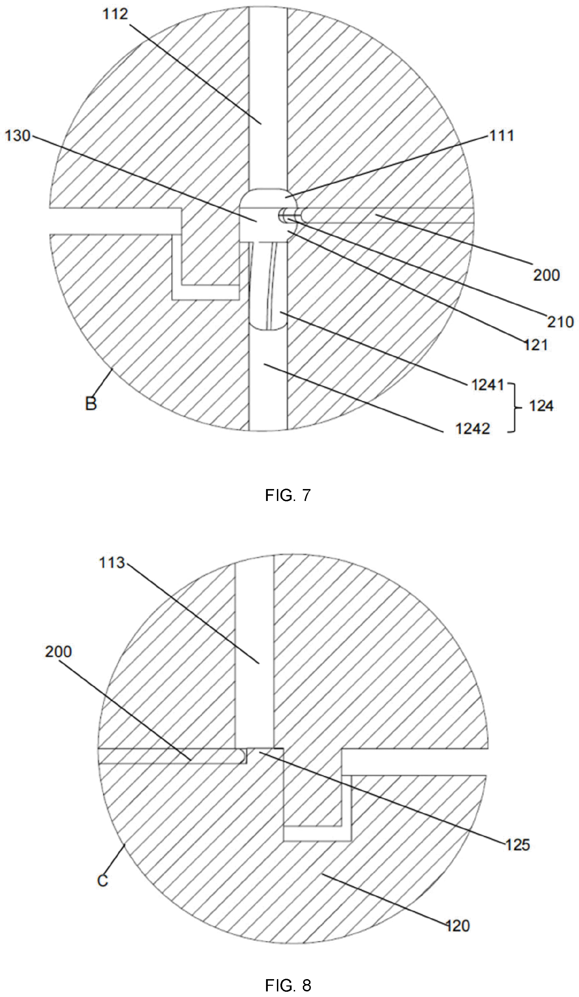

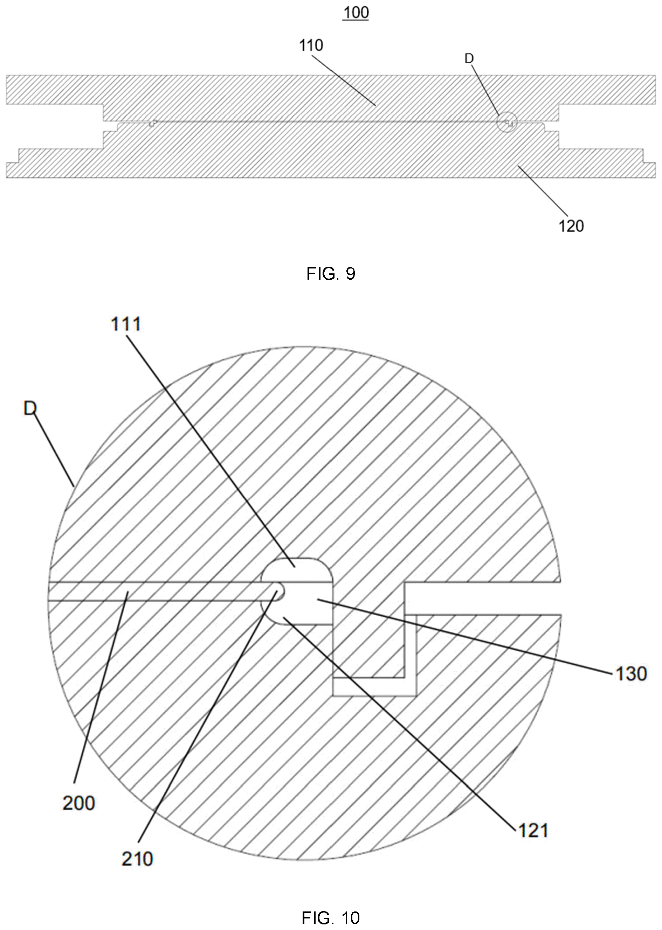

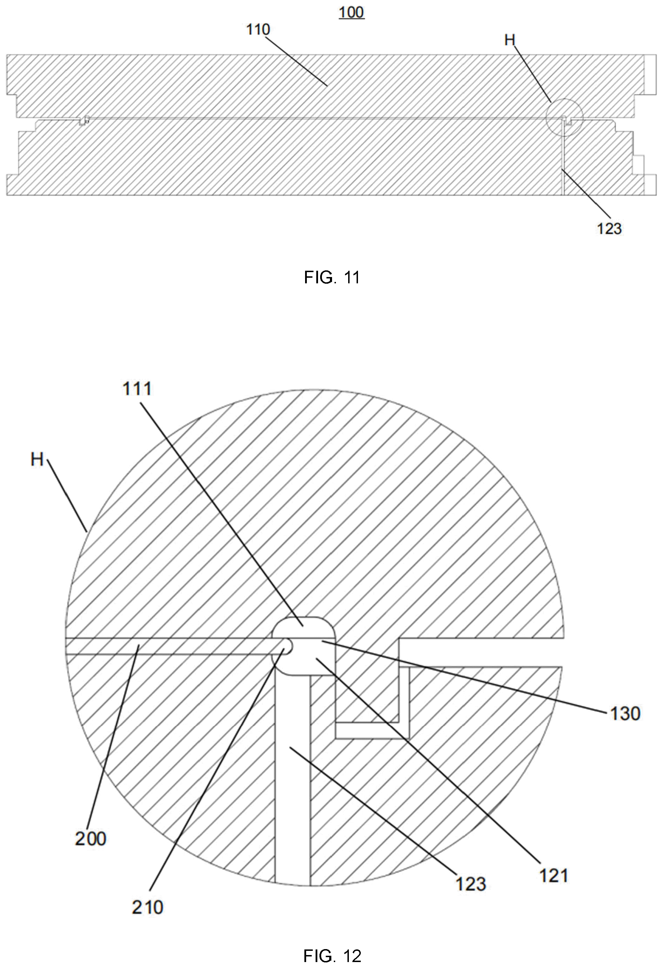

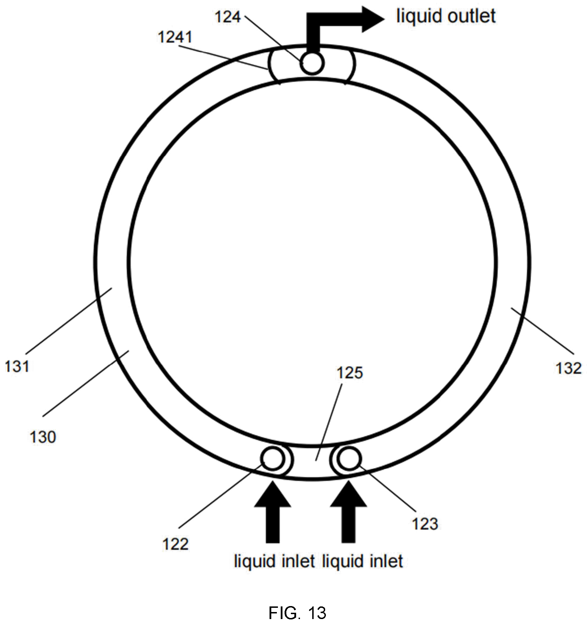

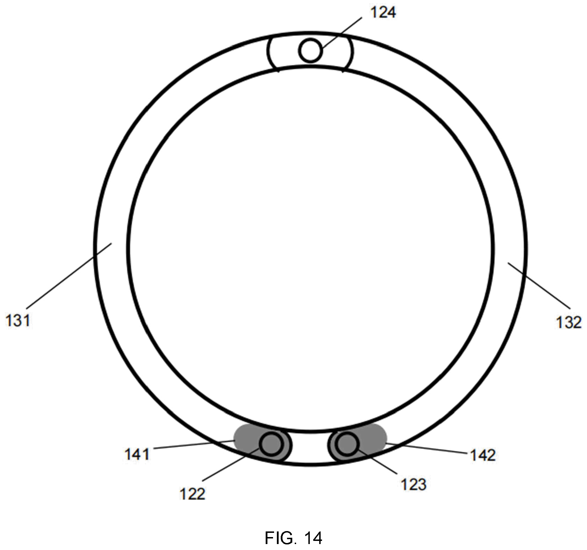

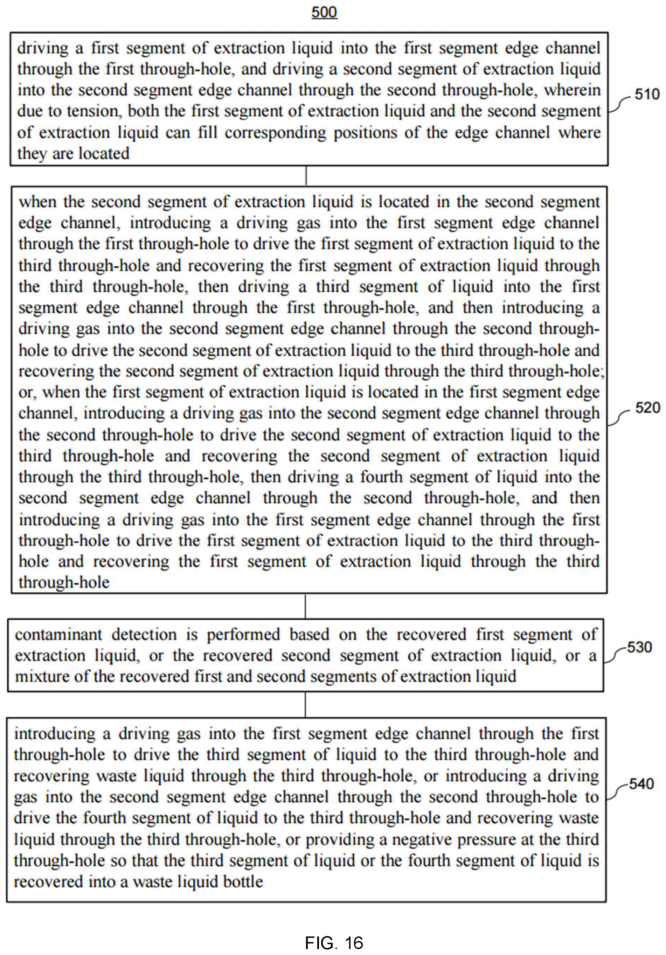

FIG. 1 is a perspective structural view of the first chamber 110 according to one embodiment; FIG. 2 is a top view of the first chamber 110 according to one embodiment. FIG.3 is a perspective structural view of the second chamber 120 according to one embodiment. FIG.4 is a top view of the second chamber 120 according to one embodiment; FIG.5 is an enlarge schematic diagram of a circle A shown in FIG. 4. FIG.6 is a cross-sectional view of the semiconductor processing device at a certain position according to one embodiment, wherein the cross-section line corresponds to line E-E in FIG.4; FIG.7 is an enlarge schematic diagram of a circle B shown in FIG.6; FIG.8 is an enlarge schematic diagram of a circle C shown in FIG.6. FIG.9 is a cross-sectional view of the semiconductor processing device at another position according to one embodiment, wherein the cross-section line corresponds to line F-F in FIG.4; FIG.10 is an enlarge schematic diagram of a circle D shown in FIG.9. FIG.11 is a cross-sectional view of the semiconductor processing device at another position according to one embodiment, wherein the cross-section line corresponds to line G-G in FIG.4. FIG.12 is an enlarge schematic diagram of a circle H shown in FIG.11. FIG. 13 is a structural diagram of the edge channel and related structures of the semiconductor processing device. FIGS. 14-15 are schematic diagrams illustrating the working principle of the edge channel and related structures in FIG.13. FIG.16 is a flowchart of the semiconductor processing method according to one embodiment.

As shown in FIGS. 1-12, the first chamber 110 has a first recessed groove 111 formed on its inner wall surface, and the second chamber 120 has a second recessed groove 121 formed on its inner wall surface. As shown in FIGS.7, 8, and 10, when the second chamber 120 is at the closed position relative to the first chamber 110 and the wafer 200 is accommodated between the second chamber 120 and the first chamber 110, the first recessed groove 111 and the second recessed groove 121 communicate with each other and jointly form an edge channel 130, and the edge 210 of the wafer 200 extends into the edge channel 130.

In one embodiment, as shown in FIGS. 3, 4, 5, 8, and 12, the second chamber 120 has a first through-hole 122, a second through-hole 123, and a third through-hole 124 that communicate the edge channel 130 with the exterior, and an isolation protrusion 125 located between the first through-hole 122 and the second through-hole 123. The first through-hole 122 and the second through-hole 123 are adjacently arranged. As shown in FIGS. 13-15, an extraction liquid entering the edge channel 130 through the first through-hole 122 flows from the first through-hole 122 to the third through-hole 124 and flows out from the third through-hole 124, and an extraction liquid entering the edge channel 130 through the second through-hole 123 flows from the second through-hole 123 to the third through-hole 124 and flows out from the third through-hole 124.

As shown in FIGS. 5, 8, and 13, the isolation protrusion 125 blocks the edge channel 130 so that the edge channel 130 forms an unclosed ring. The portion of the edge channel between the first through-hole 122 and the third through-hole 124 is referred to as a first segment edge channel 131, and the portion of the edge channel between the second through-hole 123 and the third through-hole 124 is referred to as a second segment edge channel 132.

In one embodiment, the first through-hole 122 and the second through-hole 123 are located on one side of the edge channel, and the third through-hole 124 is located on the other side of the edge channel. Preferably, in FIG.13, the length of the first segment edge channel 131 is equal to the length of the second segment edge channel 132. Of course, in other embodiments, the length of the first segment edge channel 131 and the length of the second segment edge channel 132 may be set to be unequal.

In one embodiment, the semiconductor processing device 100 can be used to perform contaminant extraction on the edge 210 of the wafer 200. FIG.16 is a flowchart of a semiconductor processing method 500 according to one embodiment, which uses the semiconductor processing device 100 to perform contaminant extraction on the edge 210 of the wafer 200. The semiconductor processing method 500 comprises the following steps.

Step 510: As shown in FIG. 14, drive a first segment of extraction liquid 141 into the first segment edge channel 131 through the first through-hole 122, and drive a second segment of extraction liquid 142 into the second segment edge channel 132 through the second through-hole 123. Due to tension, both the first segment of extraction liquid 141 and the second segment of extraction liquid 142 can fill corresponding positions of the edge channel where they are located.

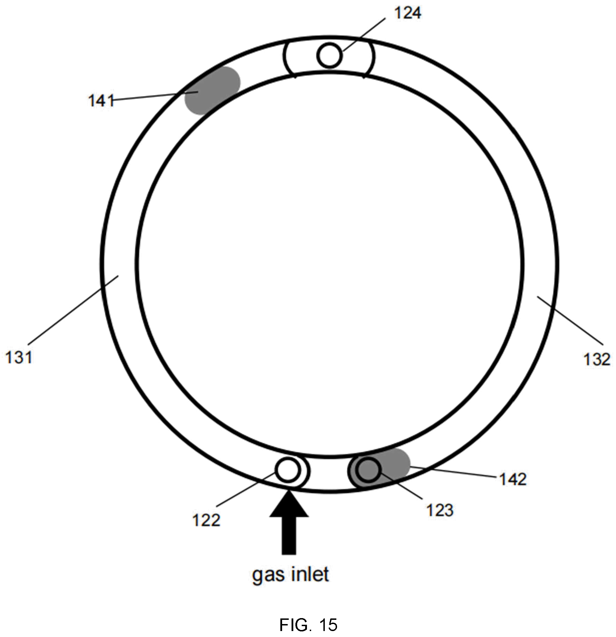

Step 520: In one embodiment, as shown in FIG. 15, when the second segment of extraction liquid 142 is located in the second segment edge channel 132, introduce a driving gas into the first segment edge channel 131 through the first through-hole 122 to drive the first segment of extraction liquid 141 to the third through-hole 124 and recover the first segment of extraction liquid 141 through the third through-hole 124, then drive a third segment of liquid (not shown) into the first segment edge channel 131 through the first through-hole (at the same location as the first segment of extraction liquid 141 in FIG.12), wherein due to tension, the third segment of liquid can fill the corresponding position of the edge channel where it is located, and then introduce a driving gas into the second segment edge channel 132 through the second through-hole 123 to drive the second segment of extraction liquid 142 to the third through-hole 124 and recover the second segment of extraction liquid 142 through the third through-hole 124. In another alternative embodiment, when the first segment of extraction liquid 141 is located in the first segment edge channel 131, introduce a driving gas into the second segment edge channel 132 through the second through-hole 123 to drive the second segment of extraction liquid 142 to the third through-hole 124 and recover the second segment of extraction liquid 142 through the third through-hole 124, then drive a fourth segment of liquid (not shown) into the second segment edge channel 132 through the second through-hole 123 (at the same location as the second segment of extraction liquid 142 in FIG.12), wherein due to tension, the fourth segment of liquid can fill the corresponding position of the edge channel where it is located, and then introduce a driving gas into the first segment edge channel 131 through the first through-hole 122 to drive the first segment of extraction liquid 141 to the third through-hole 124 and recover the first segment of extraction liquid 141 through the third through-hole 124.

Step 530: Perform contaminant detection based on the recovered first segment of extraction liquid, or the recovered second segment of extraction liquid, or a mixture of the recovered first and second segments of extraction liquid. That is, contaminant detection can be performed on the recovered first segment of extraction liquid alone or on the recovered second segment of extraction liquid alone, or the recovered first segment of extraction liquid and the recovered second segment of extraction liquid can be mixed, and then contaminant detection can be performed on the mixture. The contaminants may be metal contaminants, also referred to as metal impurities, and of course, the contaminants may also be other contaminants.

Step 540: In one embodiment, after both the first segment of extraction liquid 141 and the second segment of extraction liquid 142 are recovered, introduce a driving gas into the first segment edge channel 131 through the first through-hole 122 to drive the third segment of liquid to the third through-hole 124 and recover waste liquid through the third through-hole 124. In another embodiment, introduce a driving gas into the second segment edge channel 132 through the second through-hole 123 to drive the fourth segment of liquid to the third through-hole 124 and recover waste liquid through the third through-hole 124. In another embodiment, provide a negative pressure at the third through-hole 124 so that the third segment of liquid or the fourth segment of liquid is recovered into a waste liquid bottle. It should be noted that the third segment of liquid and the fourth segment of liquid do not exist simultaneously; either the third segment of liquid exists or the fourth segment of liquid exists.

To obtain more extraction liquid, steps 510-520 and 540 may be repeated, so that multiple first segments of extraction liquid sequentially flow through the first segment edge channel 131, and multiple second segments of extraction liquid sequentially flow through the second segment edge channel 132.

Before step 510, the semiconductor processing method 500 further comprises:
introducing a mixed gas of hydrofluoric acid into the first segment edge channel 131 and the second segment edge channel 132 through the first through-hole 122 and the second through-hole 123, respectively, and recovering exhaust gas through the third through-hole 124, to etch the edge of the wafer 200, making subsequent extraction of contaminants easier.

When the first segment of extraction liquid 141 is driven to flow from the first through-hole 122 to the third through-hole 124, the first segment of extraction liquid 141 flows over the portion of the edge of the wafer 200 that extends into the first segment edge channel 131, so as to extract contaminants on that portion of the edge of the wafer 200. When the second segment of extraction liquid 142 is driven to flow from the second through-hole 123 to the third through-hole 124, the second segment of extraction liquid 142 flows over the portion of the edge of the wafer 200 that extends into the second segment edge channel 132, so as to extract contaminants on that portion of the edge of the wafer 200. Specifically, the extraction liquid can physically or chemically react with the contaminants to dissolve the contaminants and carry them away.

As shown in FIG. 14, after driving the first segment of extraction liquid 141 into the first segment edge channel 131 through the first through-hole 122, the first segment of extraction liquid 141 is stopped at a first position, and after driving the third segment of liquid into the first segment edge channel 131 through the first through-hole 122, the third segment of extraction liquid is stopped at the first position, the first position being the location of the first through-hole 122. After driving the second segment of extraction liquid 142 into the second segment edge channel 132 through the second through-hole 123, the second segment of extraction liquid 142 is stopped at a second position, and after driving the fourth segment of liquid into the second segment edge channel 132 through the second through-hole 123, the fourth segment of liquid is stopped at the second position, the second position being the location of the second through-hole 123.

The first segment of extraction liquid 141 and the third segment of liquid (if present) provide a liquid seal at the first position of the edge channel to prevent the driving gas from passing through the first position when the driving gas is introduced through the second through-hole. The second segment of extraction liquid 142 and the fourth segment of liquid (if present) provide a liquid seal at the second position of the edge channel to prevent gas from passing through the second position when the driving gas is introduced through the first through-hole.

If, during the process of introducing a driving gas into the first segment edge channel 131 through the first through-hole 122 to drive the first segment of extraction liquid 141 to the third through-hole 124, the second segment of extraction liquid 142 is not located in the second segment edge channel 132, then due to the lack of sealing effect of the second segment of extraction liquid 142, part of the driving gas will pass through the gap between the isolation protrusion 125 and the first chamber 110 and enter the second segment edge channel 132, so that the forward speed of the first segment of extraction liquid 141 cannot be precisely controlled, and may even cause the first segment of extraction liquid 141 to be unable to advance to the third through-hole 124. If the first through-hole 122 and the second through-hole 123 are combined into one through-hole, i.e., the edge channel 130 forms a complete ring, it is impossible to precisely control a segment of extraction liquid to flow along the edge channel 130.

In one embodiment, the volumes of the first segment of extraction liquid, the second segment of extraction liquid, the third segment of liquid, and the fourth segment of liquid are all less than 3 ml, for example, the first segment of extraction liquid and the second segment of extraction liquid may be 0.5 ml, so that the total volume of the first segment of extraction liquid and the second segment of extraction liquid is 1 ml, facilitating subsequent detection and calculation. The volume of the first segment of extraction liquid is equal to the volume of the second segment of extraction liquid, and the first segment edge channel 131 and the second segment edge channel 132 are provided so that the first segment of extraction liquid and the second segment of extraction liquid can be mixed to calculate the contaminants on the edge 210 of the wafer 200. In the present invention, the volume of each segment of extraction liquid is very small, which can increase the concentration of contaminants, thereby improving the detection limit.

In the present invention, the edge channel 130 is a sealed channel, so that the extraction liquid entering the edge channel 130 through the first through-hole 122 can only flow from the first through-hole 122 to the third through-hole 124 along the edge channel 130, and the extraction liquid entering the edge channel 130 through the second through-hole 123 can only flow from the second through-hole 123 to the third through-hole 124 along the edge channel. The flow rate of the extraction liquid in the edge channel 130 is less than 5 ml/min, for example, 3 ml/min. In the present invention, the first segment of extraction liquid 141 and the second segment of extraction liquid 142 can be controlled to flow slowly and uniformly along the edge channel 130, so that the extraction liquid has sufficient time to react with contaminants on the edge of the wafer.

As shown in FIGS. 1, 2, 7, and 8, the first chamber 110 has a fourth through-hole 112 opposite the third through-hole 124, and a fifth through-hole 113 opposite the isolation protrusion 125. After the extraction liquid enters the third through-hole 124, a driving gas is introduced from the fourth through-hole 112 to make the extraction liquid leave the edge channel 130 more quickly. When performing contaminant extraction on the edge 210 of the wafer 200, a gas is introduced inward through the fifth through-hole 113 to maintain a certain gas pressure, so as to prevent the driving gas introduced through the first through-hole 122 from entering the second segment edge channel 132 through the isolation protrusion 125, and prevent the driving gas introduced through the second through-hole 123 from entering the first segment edge channel 131 through the isolation protrusion 125.

As shown in FIGS. 7 and 13, the third through-hole 124 comprises a groove engagement portion 1241 communicating with the edge channel 130 and a through-hole tube portion 1242 communicating with the groove engagement portion, the groove engagement portion 1241 serving as a funnel opening for the through-hole tube portion 1242, which makes it easier to collect the extraction liquid and prevents the flowing extraction liquid from passing over the third through-hole 124.

### Second Embodiment

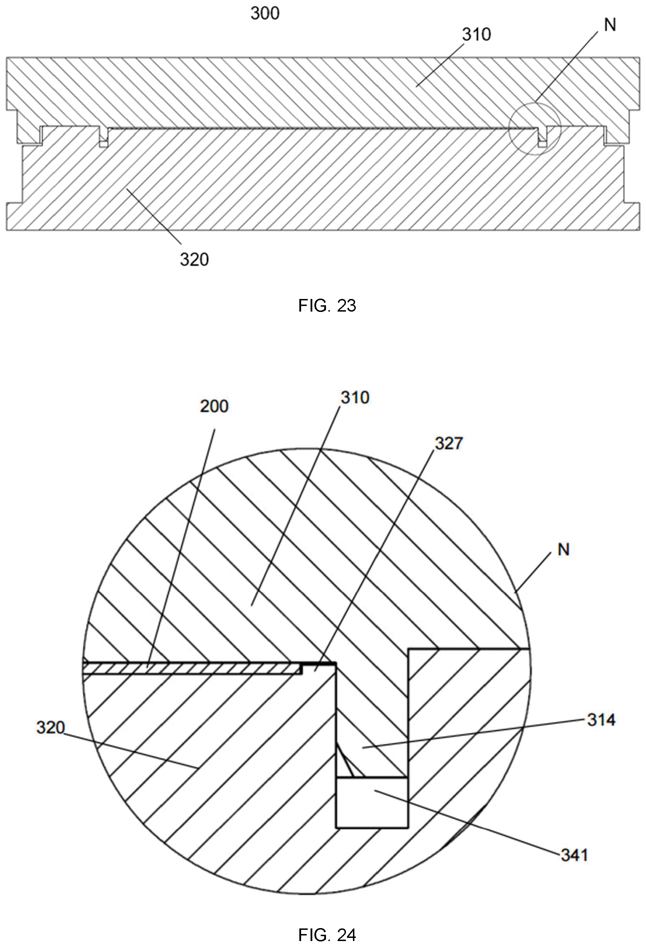

FIG. 23 is a cross-sectional view of the semiconductor processing device according to the second embodiment. As shown in FIG.23, the semiconductor processing device 300 comprises a first chamber 310 and a second chamber 320 movable relative to the first chamber 310 between an open position and a closed position. For other detailed descriptions of the semiconductor processing device 300, refer to the introduction of the semiconductor processing device 100, and the same parts in both devices will not be described again.

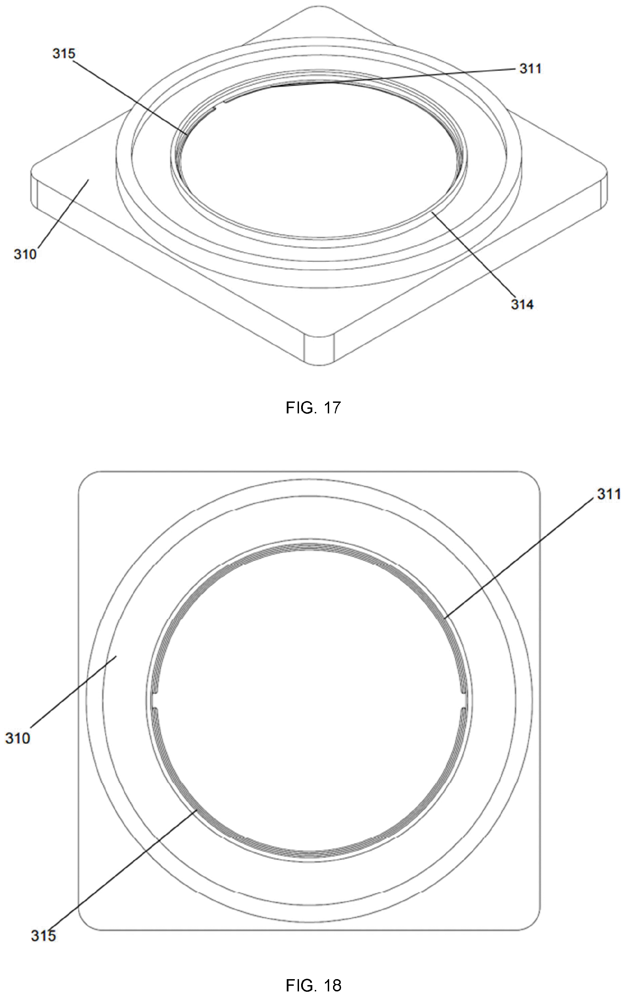

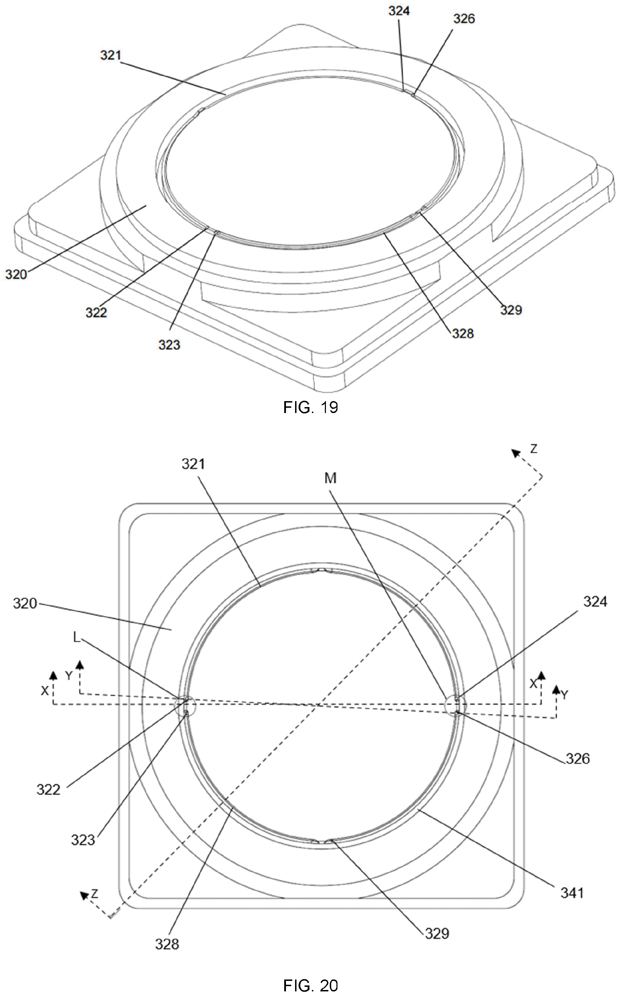

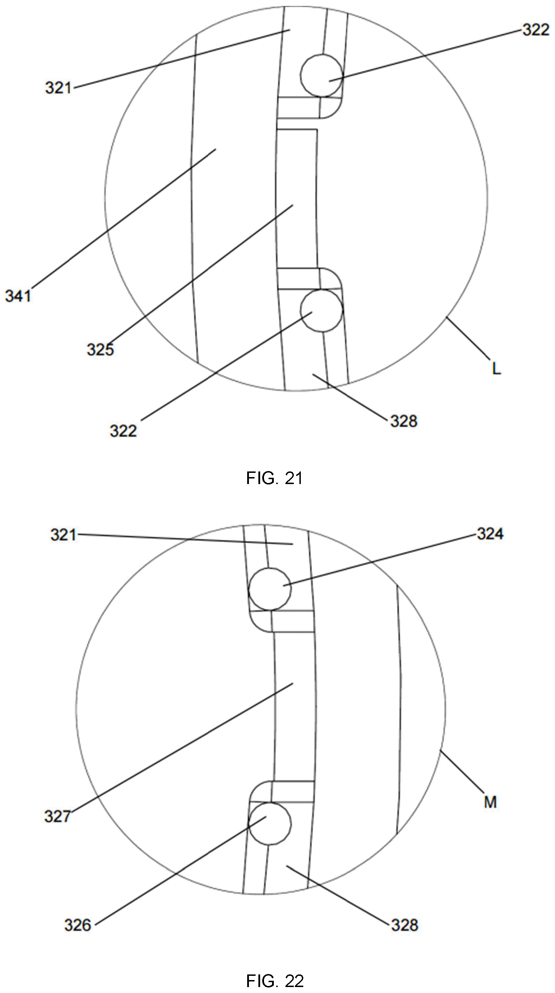

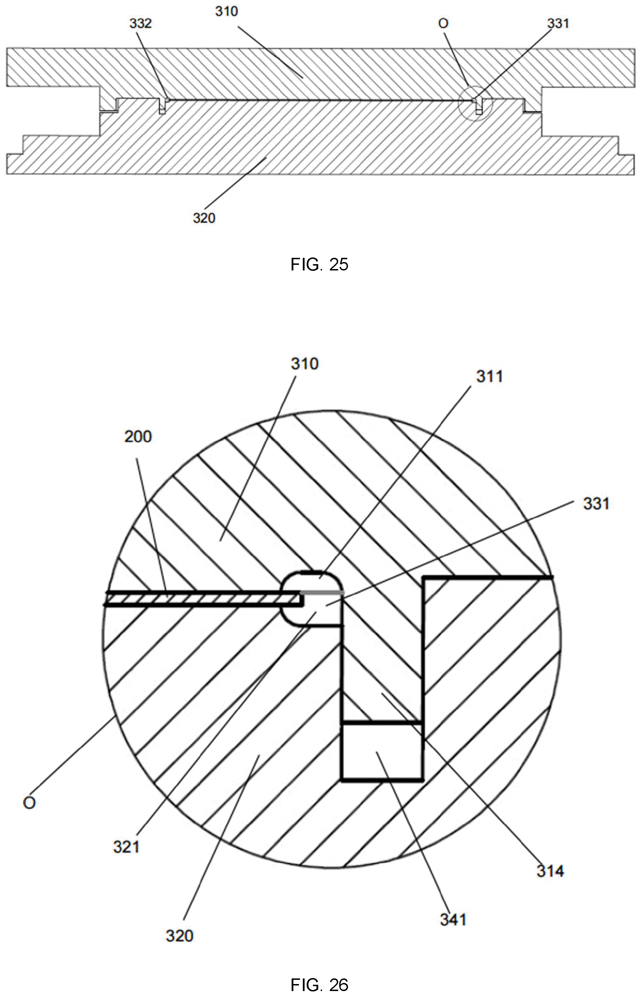

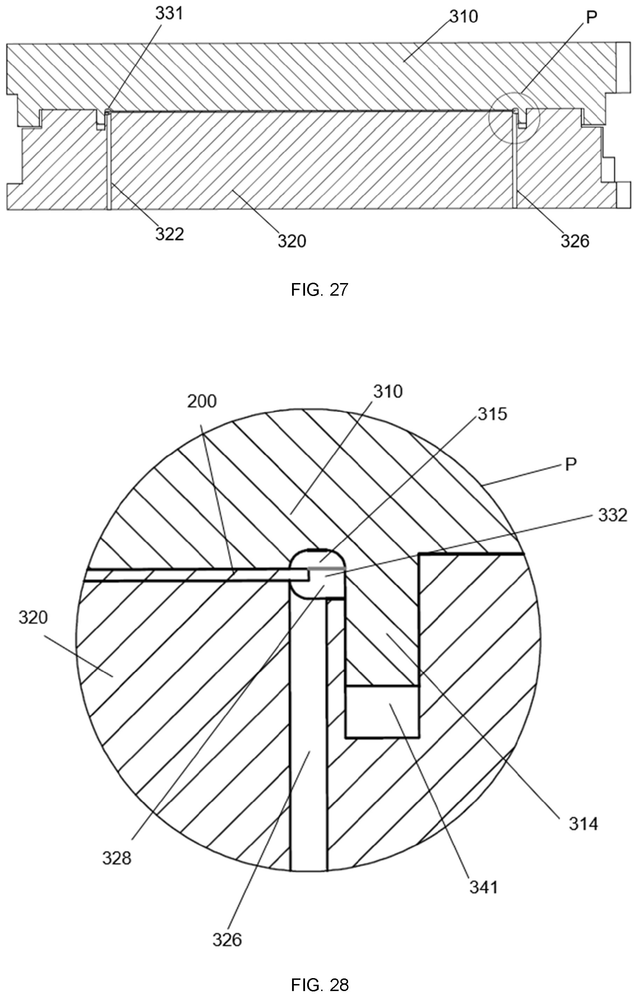

FIG. 17 is a perspective structural view of the first chamber according to the second embodiment. FIG. 18 is a top view of the first chamber according to the second embodiment. FIG. 19 is a perspective structural view of the second chamber according to second embodiment. FIG. 20 is a top view of the second chamber according to the second embodiment. FIG.21 is an enlarge schematic diagram of a circle L shown in FIG.20. FIG.22 is an enlarge schematic diagram of a circle M shown in FIG.20. FIG.23 is a cross-sectional view of the semiconductor processing device at a certain position according to the second embodiment, wherein the cross-section line corresponds to line X-X in FIG.20; FIG.24 is an enlarge schematic diagram of a circle N shown in FIG.23; FIG.25 is a cross-sectional view of the semiconductor processing device at a certain position according to the second embodiment, wherein the cross-section line corresponds to line Y-Y in FIG.20; FIG.26 is an enlarge schematic diagram of a circle O shown in FIG.25; FIG.27 is a cross-sectional view of the semiconductor processing device at a certain position according to the second embodiment, wherein the cross-section line corresponds to line Z-Z in FIG.20; FIG.28 is an enlarge schematic diagram of a circle P shown in FIG.27; FIGS.29-30 are schematic diagrams illustrating the working principle of the first segment edge channel and the second segment edge channel according to the semiconductor processing device shown in FIG.25.

As shown in FIGS. 17-30, the first chamber 310 has a first segment recessed groove 311, a second segment recessed groove 315, and an annular protruding rib 314 located outside the first segment recessed groove 311 and the second segment recessed groove 315 formed on its inner wall surface. The second chamber 320 has a third segment recessed groove 321, a fourth segment recessed groove 328, a wafer positioning portion 329 formed in the middle of the third segment recessed groove 321 and the fourth segment recessed groove 328, and an annular recessed groove 341 located outside the third segment recessed groove 321 and the fourth segment recessed groove 328. As shown in FIGS.23-28, when the second chamber 320 is at the closed position relative to the first chamber 310 and the wafer 200 is accommodated between the second chamber 320 and the first chamber 310, the annular protruding rib 314 and the annular recessed groove 341 cooperate with each other, the wafer positioning portion 329 positions the wafer 200, the first segment recessed groove 311 and the third segment recessed groove 321 communicate with each other and jointly form a first segment edge channel 331, and the second segment recessed groove 315 and the fourth segment recessed groove 328 communicate with each other and jointly form a second segment edge channel 332. A portion of the edge of the wafer 200 extends into the first segment edge channel 331, and another portion of the edge of the wafer 200 extends into the second segment edge channel 332. The wafer positioning portion 329 does not affect the flow of fluid through the first segment edge channel 331 and the second segment edge channel 332.

In the second embodiment, the second chamber 320 has a first through-hole 322 and a third through-hole 324 that communicate the first segment edge channel 331 with the exterior, and a second through-hole 323 and a fourth through-hole 326 that communicate the second segment edge channel 332 with the exterior, a first isolation protrusion 325 located between the first through-hole 322 and the second through-hole 323, and a second isolation protrusion 327 located between the third through-hole 324 and the fourth through-hole 326. The first through-hole 322 and the second through-hole 323 are adjacently arranged, and the third through-hole 324 and the fourth through-hole 326 are adjacently arranged. The first isolation protrusion 325 and the second isolation protrusion 327 cause the first segment edge channel 331 and the second segment edge channel 332 not to form a closed ring.

In one embodiment, one of the first through-hole 322 and the third through-hole 324 serves as an inlet of the first segment edge channel 331, and the other of the first through-hole 322 and the third through-hole 324 serves as an outlet of the first segment edge channel 331; one of the second through-hole 323 and the fourth through-hole 326 serves as an inlet of the second segment edge channel 332, and the other of the second through-hole 323 and the fourth through-hole 326 serves as an outlet of the second segment edge channel.

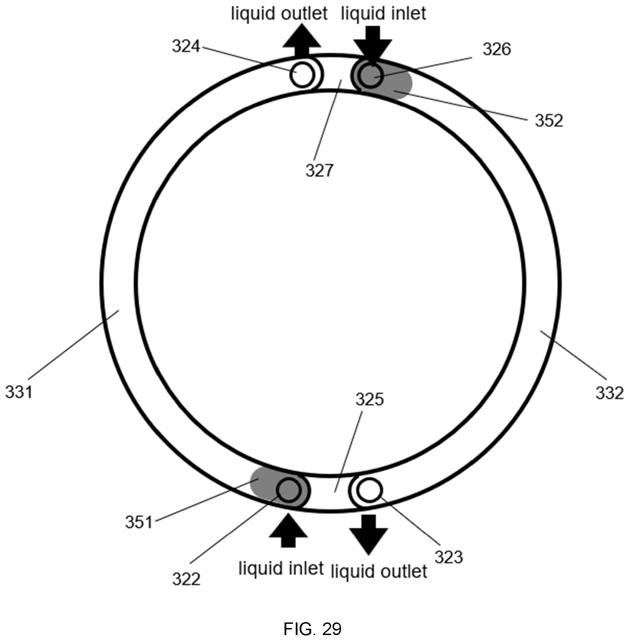

As shown in FIGS.29-30, an extraction liquid is driven to enter the first segment edge channel 331 through the corresponding inlet, flows through the first segment edge channel 331, and flows out through the corresponding outlet; an extraction liquid is driven to enter the second segment edge channel 332 through the corresponding inlet, flows through the second segment edge channel 332, and flows out through the corresponding outlet. In the preferred embodiment shown in FIGS.29-30, the first through-hole 322 serves as the inlet of the first segment edge channel 331, the third through-hole 324 serves as the outlet of the first segment edge channel 331, the fourth through-hole 326 serves as the inlet of the second segment edge channel 332, and the second through-hole 323 serves as the outlet of the second segment edge channel 332. In other embodiments, the third through-hole 324 may serve as the inlet of the first segment edge channel 331, and the second through-hole 323 may serve as the inlet of the second segment edge channel 332.

Preferably, the through-hole serving as the inlet of the first segment edge channel 331 is adjacent to the through-hole serving as the outlet of the second segment edge channel 332, and the through-hole serving as the outlet of the first segment edge channel 331 is adjacent to the through-hole serving as the inlet of the second segment edge channel 332, so that the flow direction of the extraction liquid in the first segment edge channel 331 and the flow direction of the extraction liquid in the second segment edge channel 332 can both be clockwise or counterclockwise, which makes control of the extraction liquid more precise and easier.

Preferably, the length of the first segment edge channel 331 is equal to the length of the second segment edge channel 332. Of course, in other embodiments, the length of the first segment edge channel 331 and the length of the second segment edge channel 332 may be set to be unequal.

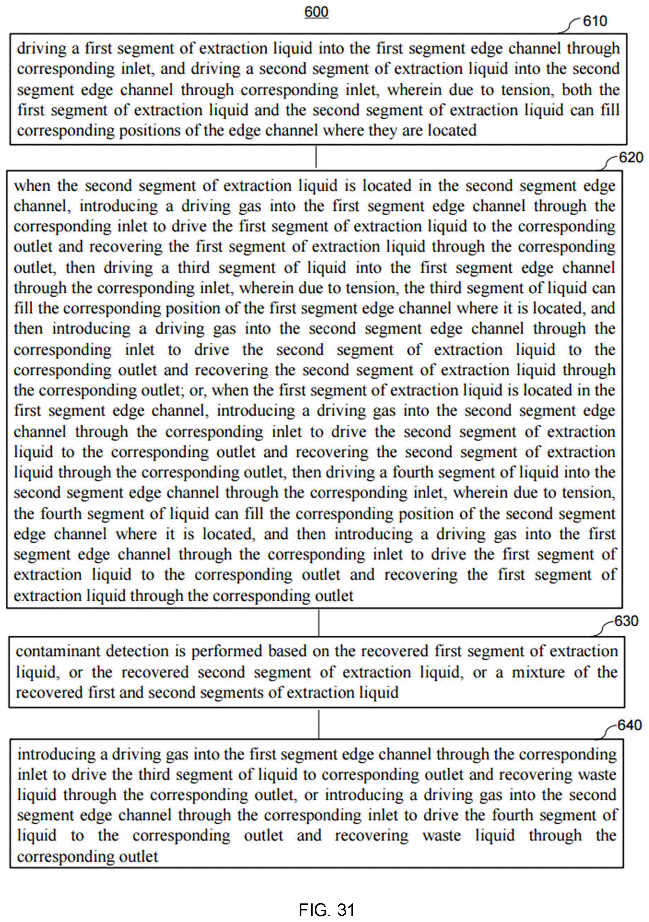

In one embodiment, the semiconductor processing device 300 can be used to perform contaminant extraction on the edge of the wafer 200. FIG.31 is a flowchart of a semiconductor processing method 600 in the second embodiment, which uses the semiconductor processing device 300 to perform contaminant extraction on the edge of the wafer 200. The semiconductor processing method 600 comprises the following steps.

Step 610: As shown in FIG. 29, drive a first segment of extraction liquid 351 into the first segment edge channel 331 through the corresponding inlet, and drive a second segment of extraction liquid 352 into the second segment edge channel 332 through the corresponding inlet, wherein due to tension, both the first segment of extraction liquid 351 and the second segment of extraction liquid 352 can fill corresponding positions of the respective segment edge channels where they are located.

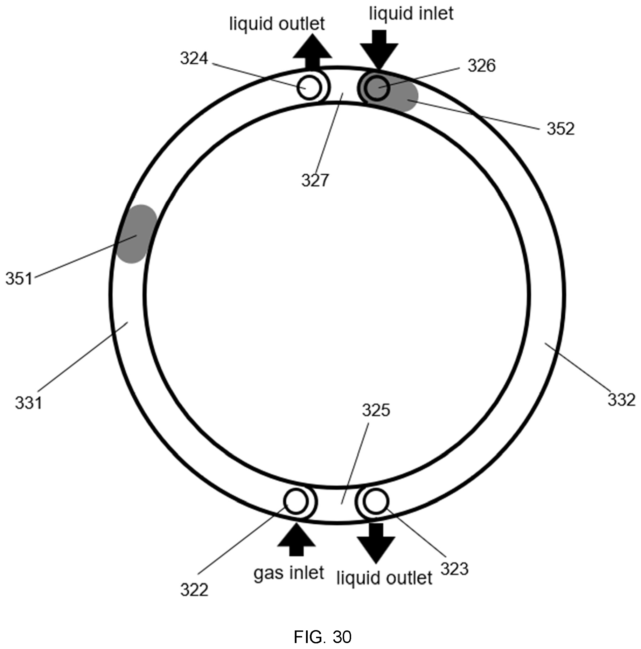

Step 620: In one embodiment, as shown in FIG. 30, when the second segment of extraction liquid 352 is located in the second segment edge channel 332, introduce a driving gas into the first segment edge channel 331 through the corresponding inlet to drive the first segment of extraction liquid 351 to the corresponding outlet and recover the first segment of extraction liquid 351 through the corresponding outlet, then drive a third segment of liquid into the first segment edge channel through the corresponding inlet, wherein due to tension, the third segment of liquid can fill the corresponding position of the first segment edge channel where it is located, and then introduce a driving gas into the second segment edge channel 332 through the corresponding inlet to drive the second segment of extraction liquid 352 to the corresponding outlet and recover the second segment of extraction liquid 352 through the corresponding outlet. In another alternative embodiment, when the first segment of extraction liquid 351 is located in the first segment edge channel 331, introduce a driving gas into the second segment edge channel 332 through the corresponding inlet to drive the second segment of extraction liquid 352 to the corresponding outlet and recover the second segment of extraction liquid 352 through the corresponding outlet, then drive a fourth segment of liquid into the second segment edge channel 332 through the corresponding inlet, wherein due to tension, the fourth segment of liquid can fill the corresponding position of the second segment edge channel 332 where it is located, and then introduce a driving gas into the first segment edge channel 331 through the corresponding inlet to drive the first segment of extraction liquid 351 to the corresponding outlet and recover the first segment of extraction liquid through the corresponding outlet. The driving gas may be nitrogen or other gases.

Step 630: Perform contaminant detection based on the recovered first segment of extraction liquid 351, or the recovered second segment of extraction liquid 352, or a mixture of the recovered first segment of extraction liquid 351 and the second segment of extraction liquid 352. That is, contaminant detection can be performed on the recovered first segment of extraction liquid alone or on the recovered second segment of extraction liquid alone, or the recovered first segment of extraction liquid and the recovered second segment of extraction liquid can be mixed, and then contaminant detection can be performed on the mixture. The contaminants may be metal contaminants, also referred to as metal impurities, and of course, the contaminants may also be other contaminants.

Step 640: In one embodiment, after both the first segment of extraction liquid 351 and the second segment of extraction liquid 352 are recovered, introduce a driving gas into the first segment edge channel through the corresponding inlet to drive the third segment of liquid to the corresponding outlet and recover waste liquid through the corresponding outlet, or introduce a driving gas into the second segment edge channel through the corresponding inlet to drive the fourth segment of liquid to the corresponding outlet and recover waste liquid through the corresponding outlet. It should be noted that the third segment of liquid and the fourth segment of liquid do not exist simultaneously; either the third segment of liquid exists or the fourth segment of liquid exists.

To obtain more extraction liquid, steps 610-620 and 640 may be repeated, so that multiple first segments of extraction liquid 351 sequentially flow through the first segment edge channel 331, and multiple second segments of extraction liquid 352 sequentially flow through the second segment edge channel 332.

Before step 610, the semiconductor processing method 600 further comprises:
introducing a mixed gas of hydrofluoric acid into the first segment edge channel 331 and the second segment edge channel 332, respectively, and recovering exhaust gas through the corresponding outlets, to etch the edge of the wafer 200, making subsequent extraction of contaminants easier. The mixed gas of hydrofluoric acid will chemically react with the natural oxide layer on the edge surface of the wafer.

When the first segment of extraction liquid 351 is driven to flow from the inlet of the first segment edge channel 331 to the corresponding outlet, the first segment of extraction liquid 351 flows over the portion of the edge of the wafer 200 that extends into the first segment edge channel 331, so as to extract contaminants on that portion of the edge of the wafer 200. When the second segment of extraction liquid 352 is driven to flow from the inlet of the second segment edge channel 332 to the corresponding outlet, the second segment of extraction liquid 352 flows over the portion of the edge of the wafer 200 that extends into the second segment edge channel 332, so as to extract contaminants on that portion of the edge of the wafer 200. Specifically, the extraction liquid can physically or chemically react with the contaminants to dissolve the contaminants and carry them away.

As shown in FIG. 29, after driving the first segment of extraction liquid 351 into the first segment edge channel 331 through the corresponding inlet, the first segment of extraction liquid is stopped at a first position, and after driving the third segment of liquid into the first segment edge channel 331 through the corresponding inlet, the third segment of extraction liquid is stopped at the first position, the first position being the location of the inlet of the first segment edge channel 331. After driving the second segment of extraction liquid 352 into the second segment edge channel 332 through the corresponding inlet, the second segment of extraction liquid is stopped at a second position, and after driving the fourth segment of liquid into the second segment edge channel 332 through the corresponding inlet, the fourth segment of liquid is stopped at the second position, the second position being the location of the inlet of the second segment edge channel.

The first segment of extraction liquid 351 and the third segment of liquid (if present) provide a liquid seal at the first position of the first segment edge channel to prevent gas from passing through the first position; the second segment of extraction liquid 352 and the fourth segment of liquid (if present) provide a liquid seal at the second position of the second segment edge channel to prevent gas from passing through the second position.

If, during the process of introducing a driving gas into the first segment edge channel 331 to drive the first segment of extraction liquid 351 to the corresponding outlet, the second segment of extraction liquid 352 is not located in the second segment edge channel 332, then due to the lack of sealing effect of the second segment of extraction liquid 352, part of the driving gas will pass through the gap between the first isolation protrusion 325 and the first chamber 110 and enter the second segment edge channel 352, so that the forward speed of the first segment of extraction liquid 351 cannot be precisely controlled, and may even cause the first segment of extraction liquid 351 to be unable to advance to the corresponding outlet or the forward speed cannot be precisely controlled.

In one embodiment, the volumes of the first segment of extraction liquid, the second segment of extraction liquid, the third segment of liquid, and the fourth segment of liquid are all less than 3 ml, for example, the first segment of extraction liquid and the second segment of extraction liquid may be 0.5 mL, so that the total volume of the first segment of extraction liquid and the second segment of extraction liquid is 1 mL, facilitating subsequent detection and calculation. The volume of the first segment of extraction liquid is equal to the volume of the second segment of extraction liquid, and the first segment edge channel 331 and the second segment edge channel 332 are provided so that the first segment of extraction liquid and the second segment of extraction liquid can be mixed to calculate the contaminants on the edge 210 of the wafer 200. In the present invention, the volume of each segment of extraction liquid is very small, which can increase the concentration of contaminants, thereby improving the detection limit and enabling high-precision detection of ultra-trace elements. The first segment of extraction liquid and the second segment of extraction liquid can both be quantified to a predetermined capacity using a quantitative loop, i.e., the volumes of the first segment of extraction liquid and the second segment of extraction liquid can be precisely controlled by a quantitative loop.

In the present invention, the first segment edge channel and the second segment edge channel are sealed channels, so that the extraction liquid entering the first edge channel 331 can only flow from the inlet to the corresponding outlet along the first edge channel 331, and the extraction liquid entering the second edge channel 332 can only flow from the inlet to the corresponding outlet along the second edge channel. The flow rate of the extraction liquid in each segment edge channel is 3-20 ml/min, for example, 3 ml/min, 5 ml/min. In the present invention, the first segment of extraction liquid 351 and the second segment of extraction liquid 352 can be controlled to travel slowly and uniformly along the first segment edge channel and the second segment edge channel, so that the extraction liquid has sufficient time to react with contaminants on the edge of the wafer.

As shown in FIGS. 23 and 24, the inner wall surface of the first chamber 110 contacts the first isolation protrusion 325 and the second isolation protrusion 327, so that the first segment edge channel and the second segment edge channel can be completely isolated. However, even so, gas may still pass through the gap between the first isolation protrusion 325 and the second isolation protrusion 327 and the inner wall surface of the first chamber 110. Before driving the extraction liquid to advance in one of the segment edge channels, it is necessary to seal the other segment edge channel with liquid.

In this way, contaminant impurities on the edge of the wafer can be extracted and detected efficiently and conveniently.

The details of the present invention can be more clearly understood with reference to the accompanying drawings and the description of the specific embodiments of the present invention. However, the specific embodiments of the present invention described herein are only for the purpose of explaining the present invention and should not be construed as limiting the present invention in any way. Under the teaching of the present invention, those skilled in the art can conceive of any possible modifications based on the present invention, which should be regarded as falling within the scope of the present invention. It should be noted that when an element is referred to as being "disposed on" another element, it can be directly on the other element or intervening elements may also be present. When an element is considered to be "connected" to another element, it can be directly connected to the other element or intervening elements may be present simultaneously. The terms "mounted," "connected," and "coupled" should be understood in a broad sense, for example, it may be a mechanical connection or an electrical connection, or it may be an internal communication between two elements, it may be a direct connection or an indirect connection through an intermediate medium. For those of ordinary skill in the art, the specific meanings of the above terms can be understood according to specific circumstances. The terms "vertical," "horizontal," "upper," "lower," "left," "right" and similar expressions used herein are for illustrative purposes only and do not represent the only embodiments.

Unless otherwise defined, all technical and scientific terms used herein have the same meaning as commonly understood by the technical personnel in this field to which this application belongs. The terms used in the specification of the present application herein are for the purpose of describing specific implementations only and are not intended to limit the present application. The term "and/or" as used herein comprises any and all combinations of one or more of the associated listed items.

Many modifications and other implementations of the present invention will come to mind of those skilled in the art having the benefit of the teachings presented in the foregoing descriptions and the associated drawings. Therefore, it is to be understood that the present invention is not to be limited to the specific embodiments disclosed and that modifications and other implementations are intended to be included within the scope of the appended claims. Moreover, although the foregoing description and the associated drawings describe example implementations of element and function combinations, alternative implementations of different combinations of elements and functions are also included within the scope of the appended claims. Different combinations of elements and/or functions than those explicitly described above are also set forth in the appended claims. Although specific terms are employed herein, they are used in a generic and descriptive sense only and not for purposes of limitation.

## Claims

1. A semiconductor processing device, **characterized by** comprising:
a first chamber;
a second chamber movable relative to the first chamber between an open position and a closed position, wherein when the second chamber is at the closed position relative to the first chamber, a wafer can be accommodated between the first chamber and the second chamber, and when the second chamber is at the open position relative to the first chamber, the wafer can be transferred into or out;
the first chamber has a first recessed groove formed on its inner wall surface, and the second chamber has a second recessed groove formed on its inner wall surface; when the second chamber is at the closed position relative to the first chamber and the wafer is accommodated between the second chamber and the first chamber, the first recessed groove and the second recessed groove communicate with each other and jointly form an edge channel, and an edge of the wafer extends into the edge channel;
the second chamber or the first chamber has a first through-hole, a second through-hole, and a third through-hole that communicate the edge channel with an exterior, and an isolation protrusion located between the first through-hole and the second through-hole, the first through-hole and the second through-hole being adjacently arranged, wherein an extraction liquid entering the edge channel through the first through-hole flows from the first through-hole to the third through-hole and flows out from the third through-hole, and an extraction liquid entering the edge channel through the second through-hole flows from the second through-hole to the third through-hole and flows out from the third through-hole.

2. The semiconductor processing device according to claim 1, wherein the isolation protrusion blocks the edge channel so that the edge channel forms an unclosed ring, a portion of the edge channel between the first through-hole and the third through-hole is referred to as a first segment edge channel, and a portion of the edge channel between the second through-hole and the third through-hole is referred to as a second segment edge channel.

3. The semiconductor processing device according to claim 2, wherein the first through-hole and the second through-hole are located on one side of the edge channel, and the third through-hole is located on the other side of the edge channel,
and the length of the first segment edge channel is equal to the length of the second segment edge channel.

4. The semiconductor processing device according to claim 2, wherein, when performing contaminant extraction on the edge of the wafer, the following operations are performed:
driving a first segment of extraction liquid into the first segment edge channel through the first through-hole, and driving a second segment of extraction liquid into the second segment edge channel through the second through-hole, wherein due to tension, both the first segment of extraction liquid and the second segment of extraction liquid can fill corresponding positions of the edge channel where they are located;
when the second segment of extraction liquid is located in the second segment edge channel, introducing a driving gas into the first segment edge channel through the first through-hole to drive the first segment of extraction liquid to the third through-hole and recovering the first segment of extraction liquid through the third through-hole, then driving a third segment of liquid into the first segment edge channel through the first through-hole, wherein due to tension, the third segment of liquid can fill the corresponding position of the edge channel where it is located, and then introducing a driving gas into the second segment edge channel through the second through-hole to drive the second segment of extraction liquid to the third through-hole and recovering the second segment of extraction liquid through the third through-hole; or, when the first segment of extraction liquid is located in the first segment edge channel, introducing a driving gas into the second segment edge channel through the second through-hole to drive the second segment of extraction liquid to the third through-hole and recovering the second segment of extraction liquid through the third through-hole, then driving a fourth segment of liquid into the second segment edge channel through the second through-hole, wherein due to tension, the fourth segment of liquid can fill the corresponding position of the edge channel where it is located, and then introducing a driving gas into the first segment edge channel through the first through-hole to drive the first segment of extraction liquid to the third through-hole and recovering the first segment of extraction liquid through the third through-hole.

5. The semiconductor processing device according to claim 4, wherein
when the first segment of extraction liquid is driven to flow from the first through-hole to the third through-hole, the first segment of extraction liquid flows over a portion of the edge of the wafer that extends into the first segment edge channel, so as to extract contaminants on that portion of the edge of the wafer,
when the second segment of extraction liquid is driven to flow from the second through-hole to the third through-hole, the second segment of extraction liquid flows over a portion of the edge of the wafer that extends into the second segment edge channel, so as to extract contaminants on that portion of the edge of the wafer,
and contaminant detection is performed based on the recovered first segment of extraction liquid, or the recovered second segment of extraction liquid, or a mixture of the recovered first and second segments of extraction liquid.

6. The semiconductor processing device according to claim 4, wherein
after driving the first segment of extraction liquid into the first segment edge channel through the first through-hole, the first segment of extraction liquid is stopped at a first position, and after driving the third segment of liquid into the first segment edge channel through the first through-hole, the third segment of extraction liquid is stopped at the first position, the first position being the location of the first through-hole,
after driving the second segment of extraction liquid into the second segment edge channel through the second through-hole, the second segment of extraction liquid is stopped at a second position, and after driving the fourth segment of liquid into the second segment edge channel through the second through-hole, the fourth segment of liquid is stopped at the second position, the second position being the location of the second through-hole,
the first segment of extraction liquid and the third segment of liquid provide a liquid seal at the first position of the edge channel to prevent gas from passing through the first position;
the second segment of extraction liquid and the fourth segment of liquid provide a liquid seal at the second position of the edge channel to prevent gas from passing through the second position.

7. The semiconductor processing device according to claim 4, wherein
the volumes of the first segment of extraction liquid, the second segment of extraction liquid, the third segment of liquid, and the fourth segment of liquid are all less than 3 ml,
the volume of the first segment of extraction liquid is equal to the volume of the second segment of extraction liquid,
the edge channel is a sealed channel so that the extraction liquid entering the edge channel through the first through-hole can only flow from the first through-hole to the third through-hole along the edge channel, and the extraction liquid entering the edge channel through the second through-hole can only flow from the second through-hole to the third through-hole along the edge channel,
after both the first segment of extraction liquid and the second segment of extraction liquid are recovered, introducing a driving gas into the first segment edge channel through the first through-hole to drive the third segment of liquid to the third through-hole and recovering waste liquid through the third through-hole, or introducing a driving gas into the second segment edge channel through the second through-hole to drive the fourth segment of liquid to the third through-hole and recovering waste liquid through the third through-hole, or providing a negative pressure at the third through-hole so that the third segment of liquid or the fourth segment of liquid is recovered into a waste liquid bottle.

8. The semiconductor processing device according to claim 4, wherein
before driving the first segment of extraction liquid and the second segment of extraction liquid into the edge channel, introducing a mixed gas of hydrofluoric acid into the first segment edge channel and the second segment edge channel through the first through-hole and the second through-hole, and recovering exhaust gas through the third through-hole,
the first chamber or the second chamber has a fourth through-hole opposite the third through-hole, and after the extraction liquid enters the third through-hole, a driving gas is introduced from the fourth through-hole to make the extraction liquid leave the edge channel more quickly,
the first chamber or the second chamber has a fifth through-hole opposite the isolation protrusion, and when performing contaminant extraction on the edge of the wafer, a gas is introduced inward through the fifth through-hole to maintain a certain gas pressure,
the third through-hole comprises a groove engagement portion communicating with the edge channel and a through-hole tube portion communicating with the groove engagement portion, the groove engagement portion serving as a funnel opening for the through-hole tube portion.

9. A semiconductor processing method based on the semiconductor processing device according to any one of claims 1-8, **characterized by** comprising:
driving a first segment of extraction liquid into the first segment edge channel through the first through-hole, and driving a second segment of extraction liquid into the second segment edge channel through the second through-hole, wherein due to tension, both the first segment of extraction liquid and the second segment of extraction liquid can fill corresponding positions of the edge channel where they are located;
when the second segment of extraction liquid is located in the second segment edge channel, introducing a driving gas into the first segment edge channel through the first through-hole to drive the first segment of extraction liquid to the third through-hole and recovering the first segment of extraction liquid through the third through-hole, then driving a third segment of liquid into the first segment edge channel through the first through-hole, wherein due to tension, the third segment of liquid can fill the corresponding position of the edge channel where it is located, and then introducing a driving gas into the second segment edge channel through the second through-hole to drive the second segment of extraction liquid to the third through-hole and recovering the second segment of extraction liquid through the third through-hole; or, when the first segment of extraction liquid is located in the first segment edge channel, introducing a driving gas into the second segment edge channel through the second through-hole to drive the second segment of extraction liquid to the third through-hole and recovering the second segment of extraction liquid through the third through-hole, then driving a fourth segment of liquid into the second segment edge channel through the second through-hole, wherein due to tension, the fourth segment of liquid can fill the corresponding position of the edge channel where it is located, and then introducing a driving gas into the first segment edge channel through the first through-hole to drive the first segment of extraction liquid to the third through-hole and recovering the first segment of extraction liquid through the third through-hole.

10. The semiconductor processing method according to claim 9, wherein the semiconductor processing method further comprises:
performing contaminant detection based on the recovered first segment of extraction liquid, or the recovered second segment of extraction liquid, or a mixture of the recovered first and second segments of extraction liquid;
when the first segment of extraction liquid is driven to flow from the first through-hole to the third through-hole, the first segment of extraction liquid flows over a portion of the edge of the wafer that extends into the first segment edge channel, so as to extract contaminants on that portion of the edge of the wafer; when the second segment of extraction liquid is driven to flow from the second through-hole to the third through-hole, the second segment of extraction liquid flows over a portion of the edge of the wafer that extends into the second segment edge channel, so as to extract contaminants on that portion of the edge of the wafer,
after both the first segment of extraction liquid and the second segment of extraction liquid are recovered, the semiconductor processing method further comprises:
introducing a driving gas into the first segment edge channel through the first through-hole to drive the third segment of liquid to the third through-hole and recovering waste liquid through the third through-hole, or introducing a driving gas into the second segment edge channel through the second through-hole to drive the fourth segment of liquid to the third through-hole and recovering waste liquid through the third through-hole, or providing a negative pressure at the third through-hole so that the third segment of liquid or the fourth segment of liquid is recovered into a waste liquid bottle;
before driving the first segment of extraction liquid and the second segment of extraction liquid into the edge channel, the semiconductor processing method further comprises:
introducing a mixed gas of hydrofluoric acid into the first segment edge channel and the second segment edge channel through the first through-hole and the second through-hole, and recovering exhaust gas through the third through-hole.

11. A semiconductor processing device, **characterized by** comprising:
a first chamber;
a second chamber movable relative to the first chamber between an open position and a closed position, wherein when the second chamber is at the closed position relative to the first chamber, a wafer can be accommodated between the first chamber and the second chamber, and when the second chamber is at the open position relative to the first chamber, the wafer can be transferred into or out;
the first chamber has a first segment recessed groove and a second segment recessed groove formed on its inner wall surface, and the second chamber has a third segment recessed groove and a fourth segment recessed groove formed on its inner wall surface; when the second chamber is at the closed position relative to the first chamber and the wafer is accommodated between the second chamber and the first chamber, the first segment recessed groove and the third segment recessed groove communicate with each other and jointly form a first segment edge channel, the second segment recessed groove and the fourth segment recessed groove communicate with each other and jointly form a second segment edge channel, a portion of an edge of the wafer extends into the first segment edge channel, and another portion of the edge of the wafer extends into the second segment edge channel;
the second chamber or the first chamber has a first through-hole and a third through-hole that communicate the first segment edge channel with the exterior, and a second through-hole and a fourth through-hole that communicate the second segment edge channel with the exterior; one of the first through-hole and the third through-hole serves as an inlet of the first segment edge channel, and the other of the first through-hole and the third through-hole serves as an outlet of the first segment edge channel; one of the second through-hole and the fourth through-hole serves as an inlet of the second segment edge channel, and the other of the second through-hole and the fourth through-hole serves as an outlet of the second segment edge channel;
an extraction liquid is driven to enter the first segment edge channel through the corresponding inlet, flows through the first segment edge channel, and flows out through the corresponding outlet;
and an extraction liquid is driven to enter the second segment edge channel through the corresponding inlet, flows through the second segment edge channel, and flows out through the corresponding outlet.

12. The semiconductor processing device according to claim 11, wherein
the first through-hole and the second through-hole are adjacent, and a first isolation protrusion is provided between the first through-hole and the second through-hole; the third through-hole and the fourth through-hole are adjacent, and a second isolation protrusion is provided between the third through-hole and the fourth through-hole;
the first isolation protrusion and the second isolation protrusion cause the first segment edge channel and the second segment edge channel not closed into a ring;
the through-hole serving as the inlet of the first segment edge channel is adjacent to the through-hole serving as the outlet of the second segment edge channel;
the through-hole serving as the outlet of the first segment edge channel is adjacent to the through-hole serving as the inlet of the second segment edge channel.

13. The semiconductor processing device according to claim 12, wherein, when performing contaminant extraction on the edge of the wafer, the following operations are performed:
driving a first segment of extraction liquid into the first segment edge channel through the corresponding inlet, and driving a second segment of extraction liquid into the second segment edge channel through the corresponding inlet, wherein due to tension, both the first segment of extraction liquid and the second segment of extraction liquid can fill corresponding positions of the edge channel where they are located;
when the second segment of extraction liquid is located in the second segment edge channel, introducing a driving gas into the first segment edge channel through the corresponding inlet to drive the first segment of extraction liquid to the corresponding outlet and recovering the first segment of extraction liquid through the corresponding outlet, then driving a third segment of liquid into the first segment edge channel through the corresponding inlet, wherein due to tension, the third segment of liquid can fill the corresponding position of the first segment edge channel where it is located, and then introducing a driving gas into the second segment edge channel through the corresponding inlet to drive the second segment of extraction liquid to the corresponding outlet and recovering the second segment of extraction liquid through the corresponding outlet; or,
when the first segment of extraction liquid is located in the first segment edge channel, introducing a driving gas into the second segment edge channel through the corresponding inlet to drive the second segment of extraction liquid to the corresponding outlet and recovering the second segment of extraction liquid through the corresponding outlet, then driving a fourth segment of liquid into the second segment edge channel through the corresponding inlet, wherein due to tension, the fourth segment of liquid can fill the corresponding position of the second segment edge channel where it is located, and then introducing a driving gas into the first segment edge channel through the corresponding inlet to drive the first segment of extraction liquid to the corresponding outlet and recovering the first segment of extraction liquid through the corresponding outlet.

14. The semiconductor processing device according to claim 13, wherein
when the first segment of extraction liquid is driven to flow from the inlet of the first segment edge channel to the corresponding outlet, the first segment of extraction liquid flows over a portion of the edge of the wafer that extends into the first segment edge channel, so as to extract contaminants on that portion of the edge of the wafer,
when the second segment of extraction liquid is driven to flow from the inlet of the second segment edge channel to the corresponding outlet, the second segment of extraction liquid flows over a portion of the edge of the wafer that extends into the second segment edge channel, so as to extract contaminants on that portion of the edge of the wafer,
and contaminant detection is performed based on the recovered first segment of extraction liquid, or the recovered second segment of extraction liquid, or a mixture of the recovered first and second segments of extraction liquid.

15. The semiconductor processing device according to claim 13, wherein
after driving the first segment of extraction liquid into the first segment edge channel through the corresponding inlet, the first segment of extraction liquid is stopped at a first position, and after driving the third segment of liquid into the first segment edge channel through the corresponding inlet, the third segment of extraction liquid is stopped at the first position, the first position being the location of the inlet of the first segment edge channel,
after driving the second segment of extraction liquid into the second segment edge channel through the corresponding inlet, the second segment of extraction liquid is stopped at a second position, and after driving the fourth segment of liquid into the second segment edge channel through the corresponding inlet, the fourth segment of liquid is stopped at the second position, the second position being the location of the inlet of the second segment edge channel,
the first segment of extraction liquid and the third segment of liquid provide a liquid seal at the first position of the first segment edge channel to prevent gas from passing through the first position;
and the second segment of extraction liquid and the fourth segment of liquid provide a liquid seal at the second position of the second segment edge channel to prevent gas from passing through the second position.

16. The semiconductor processing device according to claim 13, wherein
the volumes of the first segment of extraction liquid, the second segment of extraction liquid, the third segment of liquid, and the fourth segment of liquid are all less than 3 ml,
the first segment of extraction liquid is quantified using a quantitative loop so that the volume of the first segment of extraction liquid is a predetermined capacity,
the second segment of extraction liquid is quantified using a quantitative loop so that the volume of the second segment of extraction liquid is a predetermined capacity,
the volume of the first segment of extraction liquid is equal to the volume of the second segment of extraction liquid,
the first segment edge channel and the second segment edge channel are both sealed channels so that the extraction liquid entering the first segment edge channel can only flow from the corresponding inlet to the corresponding outlet along the first segment edge channel, and the extraction liquid entering the second segment edge channel can only flow from the corresponding inlet to the corresponding outlet along the second segment edge channel,
and after both the first segment of extraction liquid and the second segment of extraction liquid are recovered, a driving gas is introduced into the first segment edge channel through the corresponding inlet to drive the third segment of liquid to the corresponding outlet and waste liquid is recovered through the corresponding outlet, or a driving gas is introduced into the second segment edge channel through the corresponding inlet to drive the fourth segment of liquid to the corresponding outlet and waste liquid is recovered through the corresponding outlet.

17. The semiconductor processing device according to claim 13, wherein
before driving the first segment of extraction liquid into the first segment edge channel and before driving the second segment of extraction liquid into the second segment edge channel, a mixed gas of hydrofluoric acid is introduced into the first segment edge channel and the second segment edge channel.

18. The semiconductor processing device according to claim 11, wherein
the length of the first segment edge channel is equal to the length of the second segment edge channel.
